# EUROPÄISCHE PATENTSCHRIFT

(11) **EP 1 602 633 B1**
(45) Veröffentlichungstag und Bekanntmachung des Hinweises auf die Patenterteilung: **22.06.2011**
(21) Anmeldenummer: 05008122.3
(22) Anmeldetag: 14.04.2005
(51) Int. Cl.: C03C 17/00, C23C 16/40, C23C 16/453, C23C 16/30, C08J 7/06, C09D 1/00, C09D 7/00

(54) **Verwendung von optischen Schichten zur Transmissionsverbesserung und/oder Reflexionsminderung**
Use of optical layers for improvement of transmission and/or reduction of reflexion
Utilisation de couches optiques pour l'amélioration de transmission et/ou la diminution de réflexion

(30) Priorität: 20.04.2004 DE 102004019575
(43) Veröffentlichungstag der Anmeldung: 07.12.2005
(73) Patentinhaber: Innovent e.V. Technologieentwicklung, 07745 Jena (DE)
(72) Erfinder: Zobel, Bernhard, Dr., 07745 Jena (DE); Richter, Thomas, 07743 Jena (DE); Grünler, Bernd, Dr., 07937 Zeulenroda (DE)
(74) Vertreter: Hess, Peter K. G.

(56) Entgegenhaltungen:
- DE-A1- 4 237 921
- DE-A1- 10 019 926
- US-A1- 2004 087 139

## Beschreibung

Die Erfindung betrifft eine Verwendung einer optischer Schicht zur Transmissionsverbesserung und/oder Reflexionsminderung an bzw. auf Substraten, hergestellt durch Flammenbeschichtung.

Die Entspiegelung von transparenten Substraten kann entweder durch das Aufbringen von Mehrfachentspiegelungsschichten oder durch die Aufbringung einer Einfachentspiegelungsschicht erreicht werden. Die Wirkungsweise von Mehrfachentspiegelungsschichten beruht darauf, dass es durch geeigneten Schichtaufbau zu einer destruktiven Interferenz und somit zur Auslöschung bestimmter Reflexionen kommt. Bei Einfachentspiegelungsschichten wird versucht, den Brechungsindex der Schicht für die Entspiegelung von Glas möglichst auf einen Wert von 1,22 zu senken und gleichzeitig die Rauheit der Schicht auszunutzen um die Reflexion zu vermindern. Dies ist mit dichten Schichten nicht möglich. Aus diesem Grund werden solche Schichten porös, also mit einem Anteil an Luft (Brechungsindex 1), gestaltet. Die derart gestalteten Gradientenschichten weisen einen Mischbrechungsindex zwischen dem des Schichtmaterials und dem der Luft auf.
Bekanntlich werden solche Schichten mit Hilfe von Sol-Gel-Verfahren hergestellt. Hierbei wird teilweise nachträglich ein vorhandener organischer Anteil der Schicht durch eine thermische Belastung entfernt und somit die poröse Antireflexschicht hergestellt, siehe DE 19918811 A1; EP 0835849 A1; EP 0597490 B1. Es ist auch bekannt, die porösen Schichten direkt per Sol-Gel-Verfahren herzustellen, indem die partikuläre Struktur schon im Solzustand vorgebildet wird (US 4775520 A; DE 10146687 C1).
Der Nachteil dieser bekannten Verfahren besteht darin, dass Sol-Gel-Prozesse normalerweise sowohl in der Applikation als auch in der Herstellung der Sole relativ aufwendig sind. Weiterhin werden häufig teure organische Lösungsmittel eingesetzt, die für die Umwelt eine Belastung darstellen. Ein nachträgliches Tempern der Schichten und damit ein zusätzlicher Verbrauch an Energie und erhöhte Aufwendungen an Zeit sind in vielen Fällen notwendig.

Weiterhin ist es aus der DE 42 37 921 A1 bekannt, zum Hydrophilieren eines Silikatglassubstrats eine siliziumhaltige Beschichtung durch flammenhydrolytische Zersetzung der siliziumorganischen Substanzen aufzubringen. Die DE 100 19 926 A1 modifizierte eine Oberfläche eines kompakten Substrats durch flammenpyrolytische Zersetzung von Siliziumprecursoren und stellt auf diese Weise eine haftvermittelnde Schicht auf einem Glas bzw. einem PET-Substrat her. Die WO 02/14579 A1 offenbart ein Verfahren zur Herstellung einer Glasschicht auf einem Substrat, bei dem Siliziumprecursoren (gegebenenfalls unter Verwendung von Dotierungen) flammenpyrolytisch zersetzt werden. Der so hergestellte planare Wellenleiter bedarf keiner zusätzlichen Bearbeitung. In US 5 622 750 A ist ein neues Verfahren zur Herstellung eines planaren Wellenleiters beschrieben, das die flammenpyrolytische Zersetzung von Siliziumprecursoren unter zusätzlicher Verwendung von Dotanten nutzt. Die vier letztgenannten Dokumente haben einzig und allein die Erzeugung von hydrophilen bzw. haftungsvermittelnden Schichten oder der Erzeugung von planaren Wellenleitern zum Ziel.

Die vorliegende Erfindung soll diese Nachteile vermeiden.

Gemäß der Erfindung wird dies durch die Merkmale des ersten Patentanspruchs erreicht und durch vorteilhafte Ausgestaltungen gemäß den Unteransprüchen ergänzt. Die auf diese einfache Weise hergestellten Schichten zeigen gute Entspiegelungswerte sowohl bei senkrechtem als auch bei schrägem Einfall des Lichtes. Dies trifft sowohl auf den sichtbaren als auch auf den längerwelligen Anteil des Lichtes zu. Die Anwendung des an sich bekannten Verfahrens der Flammenpyrolyse zur Zersetzung von Siliziumprecursoren für die Herstellung von strukturierten Einfachschichten benötigt die nach dem Stand der Technik im Anschluss an ein Sol/Gel Verfahren notwendigen mechanischen bzw. thermischen Strukturierungen der aufgebrachten Schicht nicht.
Zur Schichtherstellung können sowohl ein Brenner als auch mehrere Brenner Verwendung finden, deren thermische Leistung pro Flammenaustrittsfläche 0,5 bis 10 kW/10 cm², vorzugsweise 6 kW/10 cm² beträgt. Das Substrat kann sich im Herstellungsprozess vorzugsweise innerhalb der Brennerflamme befinden. Die Substrattemperatur von 20°C bis 300°C gilt für das Innere des Substrates und kann an der Substratoberfläche höher liegen. Die Geschwindigkeit der Relativbewegung zwischen Brenner und ein- oder beidseitig zu beschichtendem Substrat in Höhe von 10 bis 20000 mm/s ist abhängig vom Substrat und von der aufzutragenden Schichtdicke. Für Glas kann sie bspw. 12 bis 200 mm/s betragen. Der Abstand zwischen Brenner und Substrat in Höhe von 3 bis 200 mm ist so bemessen, dass sich das Substrat möglichst innerhalb der Flamme befindet. Der Brenner ist mit seiner Achse vorzugsweise senkrecht zum Substrat gerichtet; die Achse kann auch bis zu einem Winkel von 45° aus der Senkrechten abweichen. Als Precursoren dienen Siliziumverbindungen der allgemeinen Formel R₍₄₋ₙ₎SiXₙ (n = 0-4; R = organischer Rest; X = Halogen, OH; OR; z.B. Me₄Si, Me₃Si-O-SiMe₃). Es kann auch eine anorganische Siliziumverbindung, wie z. B. SiCl₄ als Precursor verwendet werden. Die Brenngase können flüssige und/oder gasförmige Kohlenwasserstoffe und/oder Wasserstoff sein, vorzugsweise kann Butan oder Propan oder deren Gemische oder Erdgas verwendet werden. Als Oxydator kommt Luft, Sauerstoff oder ein Gemisch von Luft und Sauerstoff in Anwendung. Die herzustellenden Schichtdicken liegen zwischen 5 nm und 200 nm, vorzugsweise zwischen 20 nm und 100 nm. Die erfindungsgemäßen Schichten weisen einen RMS-Wert (Rauhigkeit) von 3-50 nm, bevorzugt 5-30 nm, besonders bevorzugt 10-25 nm auf. Als Substrate können sowohl Glas in Form von Floatglas oder Gussglas, beschichtet oder unbeschichtet, mit und ohne Einlagen als auch Keramik als auch Kunststoffe als auch Metalle verwendet werden. Nach dem Material der Substrate richtet sich die vorteilhafte Wirkung der optischen Schichten. Die Precursorkonzentration soll zwischen 0,05 Vol%/l Brenngas und 5 Vol%/l Brenngas, vorzugsweise 0,1-1,0 Vol%/l Brenngas liegen. Dabei bezieht sich die Prozentangabe auf Precursoren mit einem Si-Atom. Bei Precursoren mit mehr als einem Si-Atom pro Molekül müssen die entsprechenden Vol% durch die Anzahl der Si-Atome geteilt werden.

Die Erfindung wird nachstehend an Hand der schematischen Zeichnung näher erläutert. Es zeigen:
- Fig. 1: ein Blockschema einer Beschichtungsanlage,
- Fig. 2: einen Ausschnitt aus dieser Beschichtungsanlage,
- Fig. 3: eine Darstellung zum Beschichtungsprozess,
- Fig. 4und 5: die Abhängigkeit der Transmissionserhöhung von einem ersten Substrat,
- Fig. 6 und 7: die Abhängigkeit der Transmissionserhöhung von einem zweiten Substrat,
- Fig. 8 und 9: die Abhängigkeit der Transmissionserhöhung von einem dritten Substrat,
- Fig. 10 und 11: die Abhängigkeit der Transmissionserhöhung von einem vierten Substrat und
- Fig. 12: die Abhängigkeit der Reflexionsminderung von einem fünften Substrat.

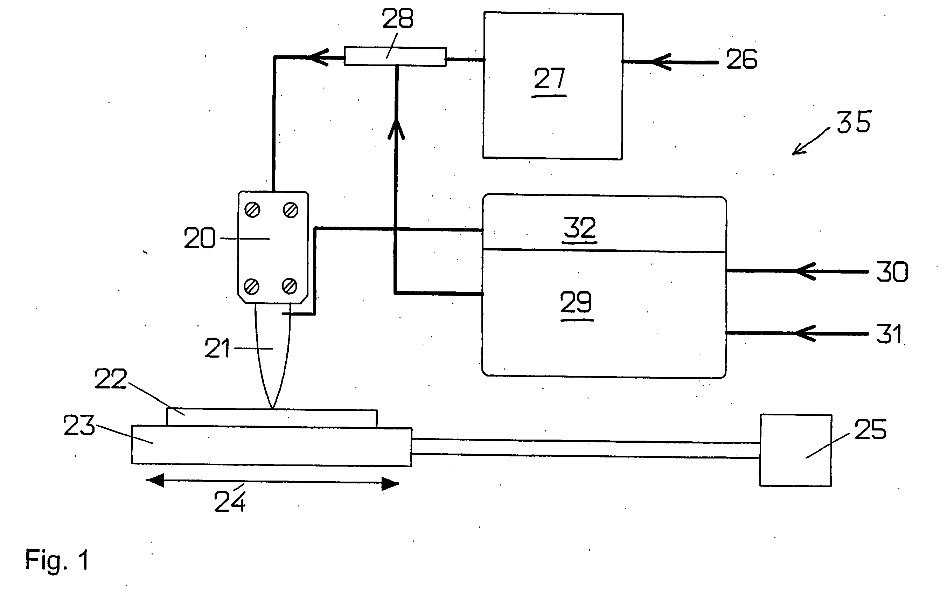

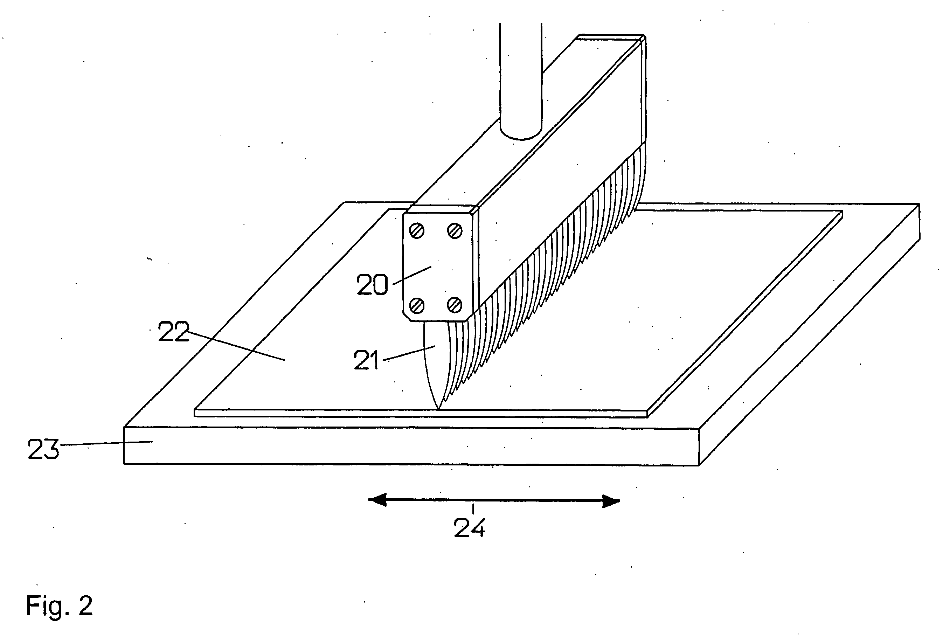

In den Figuren 1 bis 3 ist eine automatische Beschichtungsvorrichtung 35 dargestellt, bei der ein Brenner 20 mit einer Flamme (oder mehreren Flammen) 21 sich gegenüber einem Substrat 22, das sich auf einem Träger 23 befindet, bewegt. Das Substrat befindet sich in einem Abstand von bspw. 40 mm vom Brenner. Die Substratbewegung ist durch einen Doppelpfeil 24 dargestellt. Es ist allerdings auch möglich, dass der Brenner oder Brenner und Substrat bewegt werden. Das Substrat 22 wird mit Hilfe einer Beheizungseinrichtung 25 temperiert. Ein Precursor (z. B. Me₄Si, Me₃Si-O-SiMe₃) 26 wird über eine Dosierungseinrichtung 27 einem Mischsystem 28 zugeführt, an das eine Brenngas-Oxydatorregelung 29 angeschlossen ist. In der Brenngas-Oxydatorregelung werden ein Brenngas (z. B. Propan) 30 und ein Oxydator (z. B. Luft) 31 im geeigneten Verhältnis gemischt. Das so entstandene Mischgas gelangt in das Mischsystem 28 (Precursorzumischung) und von da in den Brenner 20. Dort wird das Mischgas verbrannt. Zur Brennerüberwachung dient ein Sensorsystem mit Anzeige 32. Zur Herstellung einer transmissionsverbessernden und/oder reflexmindernden Schicht 33 entsprechender Dicke wird das Substrat 22 in durch den Doppelpfeil 24 angegebenen Richtungen hin und her bewegt, wobei sich SiOₓOH)₍₄₋₂ₓ₎-Partikel 34 auf dem Substrat 22 als transmissionsverbessernde und/oder reflexionsmindernde Schicht abscheiden.
Anstatt im Mischsystem 28 kann der Precursor auch an der Brennerflamme zugemischt werden, wobei er mit Hilfe eines Oxydators hydrolytisch zersetzt wird.

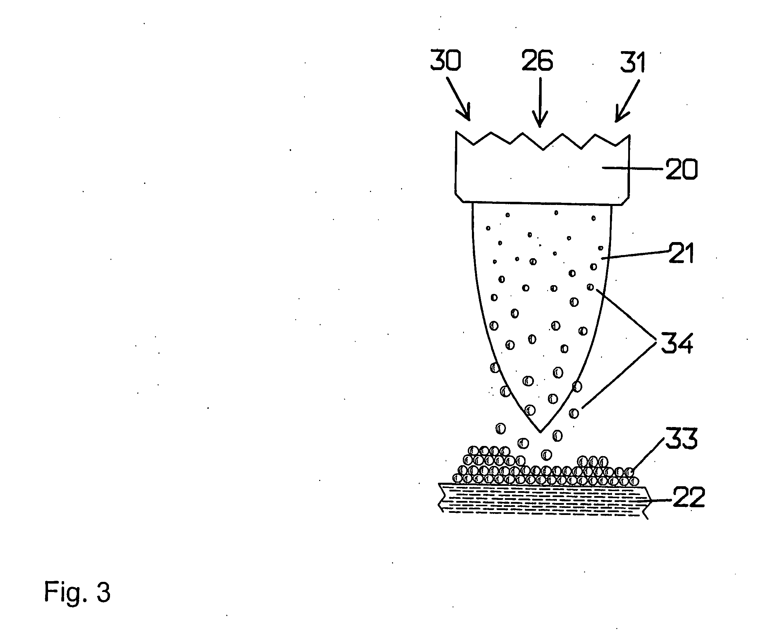

In Fig. 3 ist aus Übersichtlichkeitsgründen das Substrat 22 an der Spitze der Flamme 21 vorgesehen. Vorteilhaft befindet es sich jedoch innerhalb der Flamme 21.

Im Folgenden wird anhand von 5 Ausführungsbeispielen die Schichtherstellung auf fünf unterschiedlichen Substraten beschrieben.

### Ausführungsbeispiel 1

Mit Hilfe der in den Figuren 1 bis 3 dargestellten automatischen Beschichtungseinrichtung wird eine 85.70 mm² große Weißglasscheibe mit einer Dicke von 4 mm ein- und beidseitig mit einer Si, O und H enthaltenen Schicht der allgemeinen Zusammensetzung SiOₓ(OH)₍₄₋₂ₓ₎ (x = 0-2) beschichtet. Zur Schichtabscheidung wird ein Brenner mit einer thermischen Leistung von 6kW/10 cm² verwendet. Die Substratgeschwindigkeit beträgt 50 mm/s und der Beflammungsabstand (zwischen Brenner und Substrat) 40 mm. Als oxidierendes Medium wird Luft verwendet, die mit 200 l/min zugeführt und mit einem Brenngas gemischt wird, das aus mit 0,3 Vol% Hexamethydisiloxan dotiertem Propan besteht und mit 8 1/min zugeführt wird. Das Substrat wird vor der Beflammung in einem Umluftofen auf 80° C vorgewärmt. Während der Beschichtung wird eine Temperplatte (Träger) als Gegenkühlung mit 80° C verwendet. Diese Prozedur wird an drei gleichen Substraten durchgeführt.

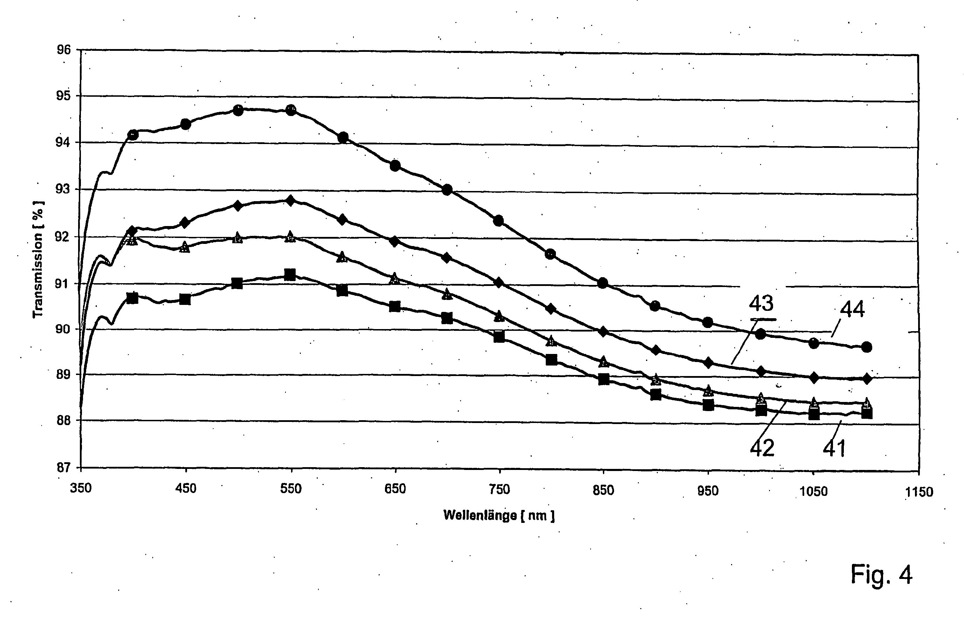

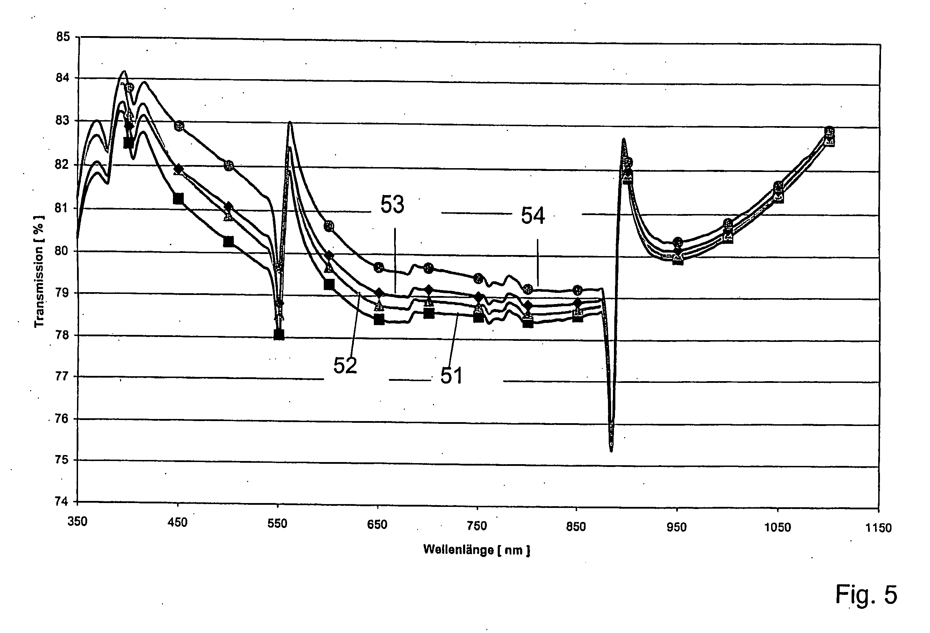

Nach dem Abkühlen werden die beschichteten Substrate 22 spektroskopisch in Transmission unter 90° und 45° Lichteinfallswinkel vermessen und jeweils ein Mittelwert gebildet. Die Ergebnisse bezüglich der Verbesserung der wellenlängenbezogenen Lichttransmission in Abhängigkeit von der Behandlung und deren Wiederholungen sind für 90° Lichteinfallswinkel der Fig. 4 entnehmbar. Darin stellt die Kurve 41 die Transmission bei unbehandelten Oberflächen des Substrates dar. Die Kurve 42 zeigt die Transmission nach vier Durchläufen bei einseitig beschichtetem Substrat. Die Kurve 43 zeigt ebenfalls die Transmission bei einseitig beschichtetem Substrat, aber nach 8 Durchläufen. Die Kurve 44 zeigt die Transmission nach 8 Durchläufen bei beidseitiger Beschichtung des Substrates.
Bei einem Lichteinfallswinkel von 45° ergeben sich entsprechende Werte, die den Kurven 51, 52, 53, 54 der Fig. 5 entnehmbar sind. Es ist zu erkennen, dass mit steigender Zahl der Beschichtungszyklen und somit erhöhter Schichtdicke eine Transmissionsverbesserung einhergeht. Dieser Effekt lässt sich durch die Beschichtung beider Seiten des Substrates verdoppeln.

### Ausführungsbeispiel 2

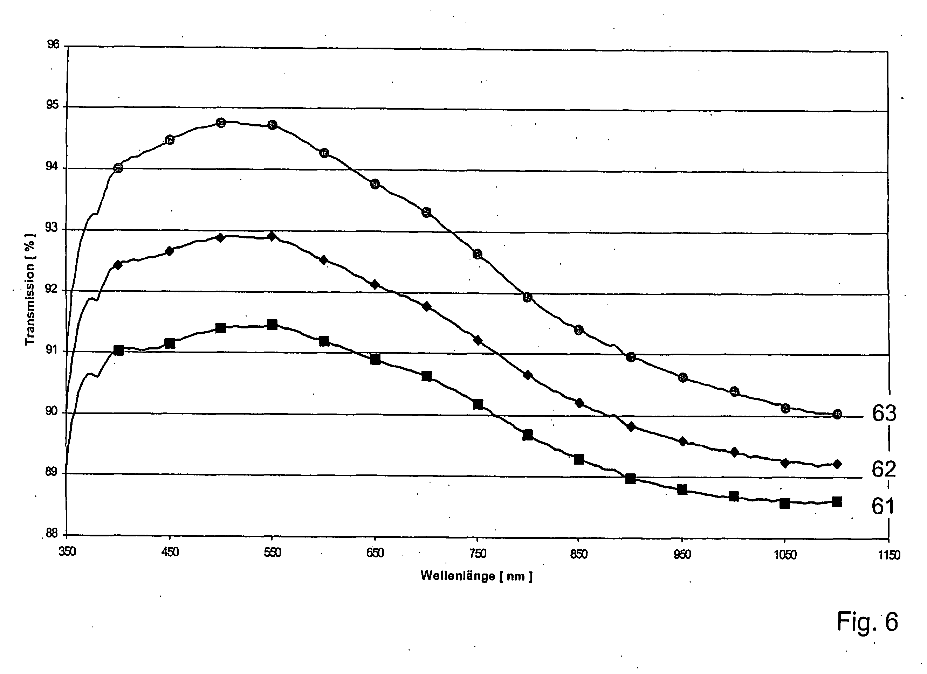

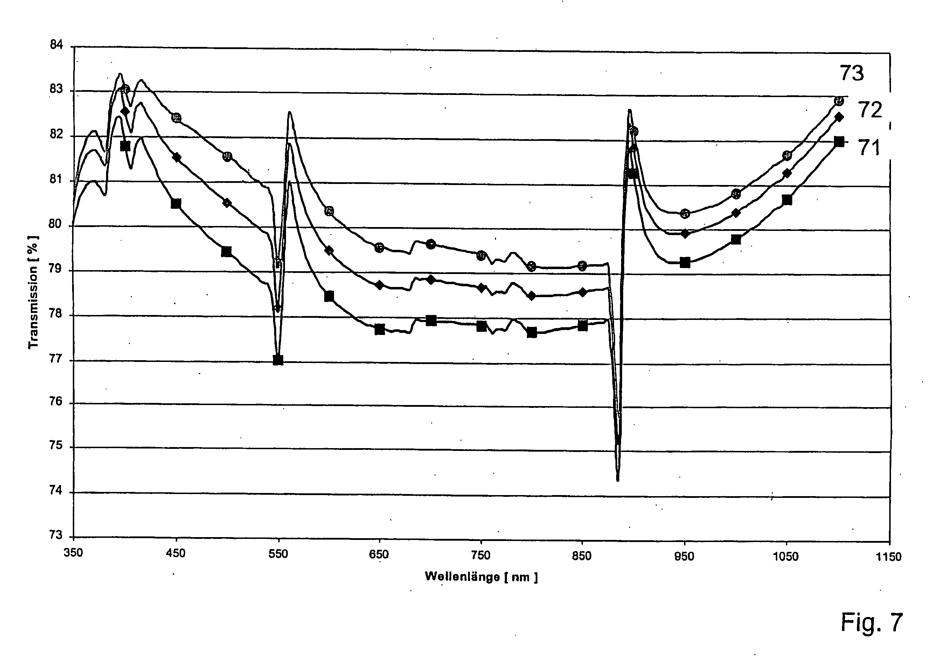

Ähnlich wie beim Ausführungsbeispiel 1 wird eine 85.70 mm² große ESG-Scheibe (Weißglas, 4 mm dick) ein- und beidseitig mit einer Si, O und H enthaltenden Schicht der bereits genannten allgemeinen Zusammensetzung beschichtet. Die Parameter des Brenners, der Substratbewegung, des Beflammungsabstandes, des oxidierenden Mediums, des Brenngases, der Vorwärmung und Gegenkühlung sind die gleichen wie in Ausführungsbeispiel 1. Auch in diesem Fall wird die Beschichtung dreimal wiederholt. Nach Abkühlung der Substrate werden die Transmissionen ebenfalls unter 90° und 45° Lichteinfallswinkel vermessen und jeweils der Mittelwert gebildet. Die Abhängigkeit der Transmissionserhöhungen bei 90° Lichteinfallswinkel und bei 45° Lichteinfallswinkel sind den Figuren 6 und 7 entnehmbar. Und zwar stellen die Kurven 61, 62, 63 die Transmissionen dar, die sich bei einem Lichteintrittswinkel von 90° für eine unbehandelte ESG-Substratoberfläche bzw. für eine einseitig beschichtete ESG-Substratoberfläche bzw. für eine beidseitig beschichtete ESG-Substratoberfläche ergeben. Die Kurven 71, 72, 73 ergeben sich bei einem Lichteinfallswinkel von 45° für eine unbehandelte bzw. eine einseitig beschichtete bzw. eine beidseitig beschichtete ESG-Substratoberfläche, wobei die Beschichtungen mit jeweils 8 Durchläufen vorgenommen werden. Aus den Figuren 6 und 7 ist deutlich, dass durch die Beschichtung beider Seiten des Substrates sich die Transmissionserhöhung verdoppeln lässt.

### Ausführungsbeispiel 3

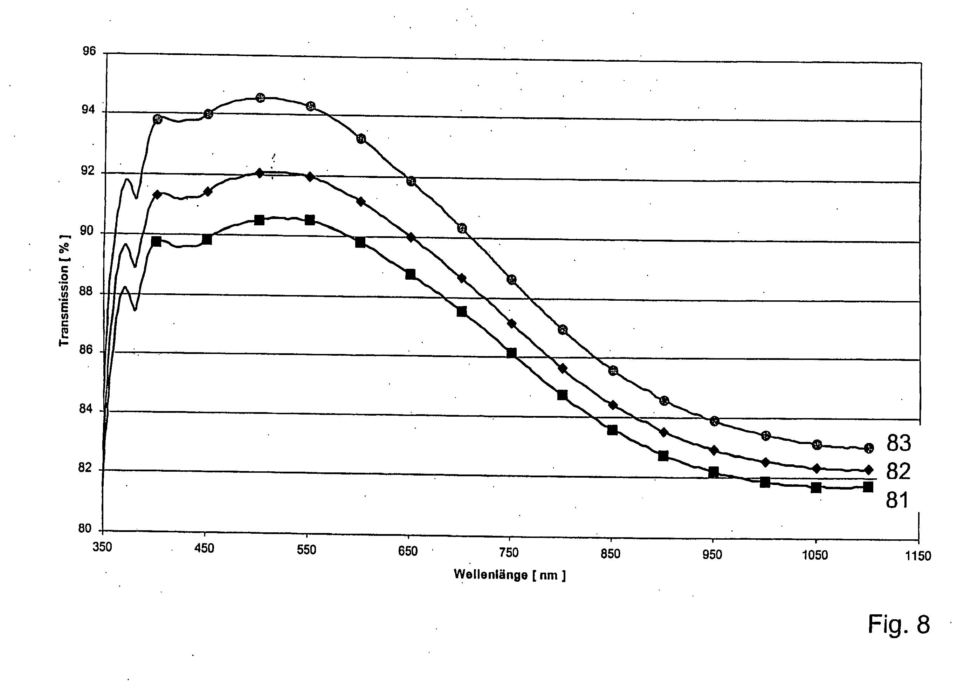

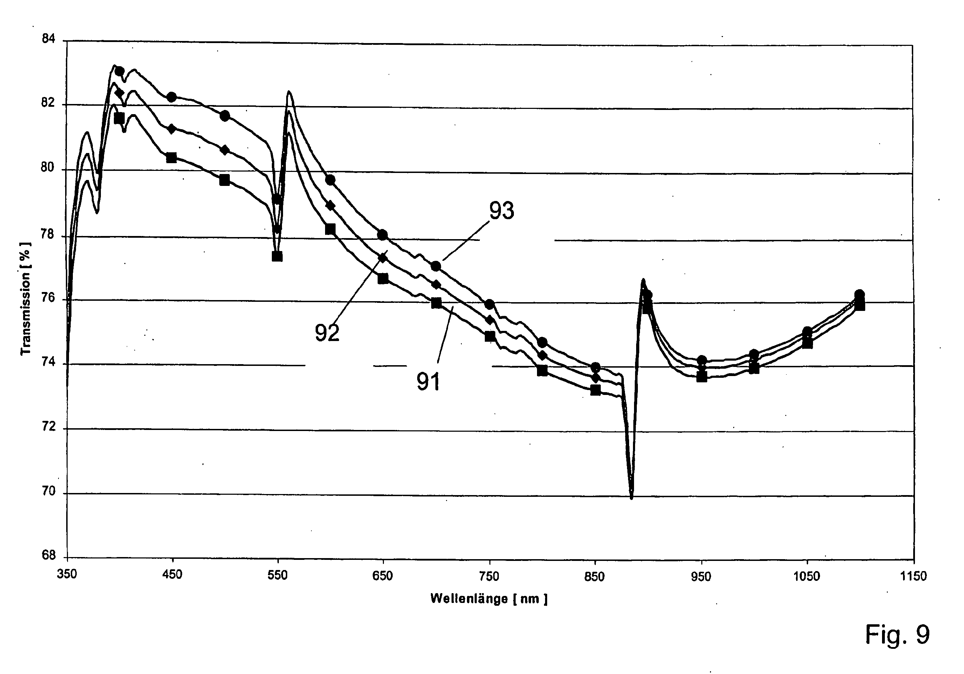

Im dritten Ausführungsbeispiel dient als Substrat eine Floatglasscheibe, wobei die Parameter der Behandlung dieselben sind, wie in den vorangegangenen Ausführungsbeispielen. Auch die Anzahl der Durchläufe der Beschichtung einseitig und beidseitig sind dieselben. Es ergeben sich für Lichteinfallswinkel von 90° und 45° spektroskopisch bestimmte Transmissionen, die in den Figuren 8 und 9 festgehalten sind. In Fig. 8 stellt die Kurve 81 die Transmission der unbeschichteten Substratoberfläche, die Kurve 82 die Transmission der einseitig beschichteten Substratoberfläche nach 8 Durchläufen und die Kurve 83 die Transmission der beidseitig beschichteten Substratoberfläche nach 8 Durchläufen dar. In Fig. 9 sind bei einem Lichteinfallswinkel von 45° die entsprechenden Transmissionen durch die Kurven 91, 92 und 93 festgehalten. Die Verbesserung der Lichttransmissionen durch die Beschichtungen lassen sich diesen Figuren eindeutig entnehmen.

### Ausführungsbeispiel 4

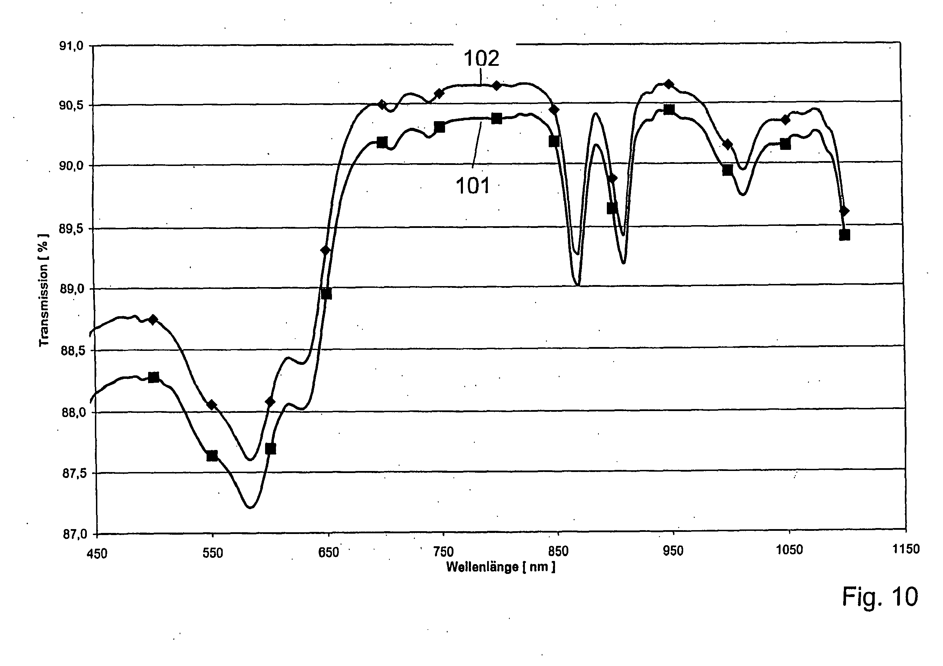

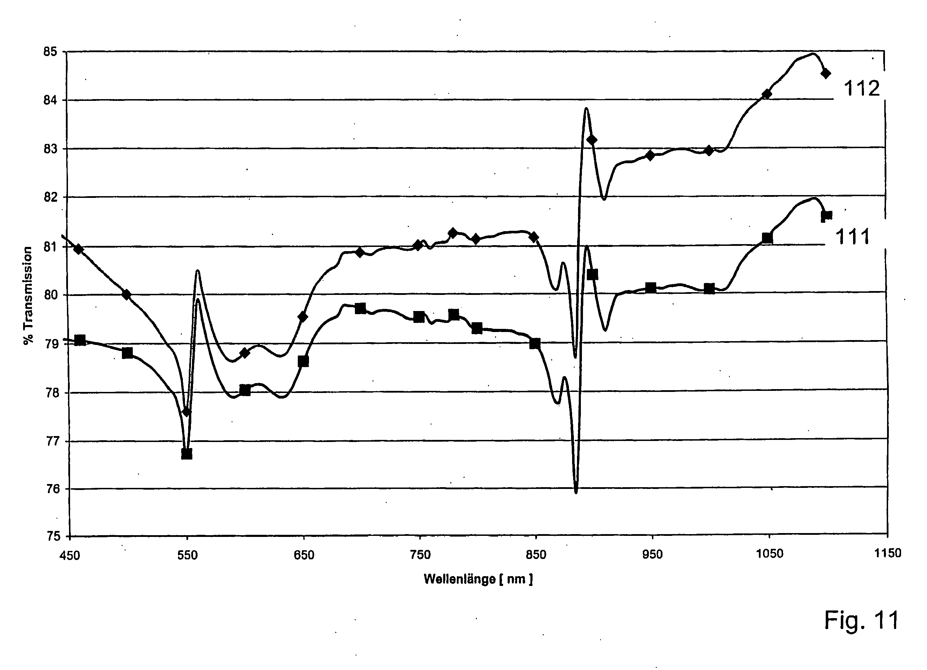

Eine Polycarbonatplatte von 4 mm Dicke und 85·70 mm² Größe wird beidseitig mit einer Si, O und H enthaltenden Schicht der vorgenannten allgemeinen Zusammensetzung flammenbeschichtet. Die Beschichtung erfolgt mit 10 Durchläufen und einer Geschwindigkeit von 500 mm/s. Der Beflammungsabstand, das oxidierende Medium, das Brenngas und seine Zuführungsmenge, sind die gleichen wie in den vorangegangenen Ausführungsbeispielen. Die Vorwärmung und die Gegenkühlung wurde bei 60° C durchgeführt. Nach dem Abkühlen des Substrates wird die Transmission spektroskopisch vermessen, und zwar wieder unter Berücksichtigung von Lichteinfallswinkeln von 90° und 45° zum Substrat. Die Ergebnisse sind für 90° und 45° Lichteinfallswinkel in den Figuren 10 und 11 festgehalten, und zwar zeigen die Kurven 101 und 111 die Transmission der unbeschichteten Polycarbonatplatte und die Kurven 102 und 112 die Transmission der beidseitig beschichteten Polycarbonatplatte nach 10 Beschichtungsdurchläufen. Daraus lässt sich erkennen, dass auch auf Substraten aus Kunststoff eine deutliche Transmissionsverbesserung erzielt werden kann.

### Ausführungsbeispiel 5

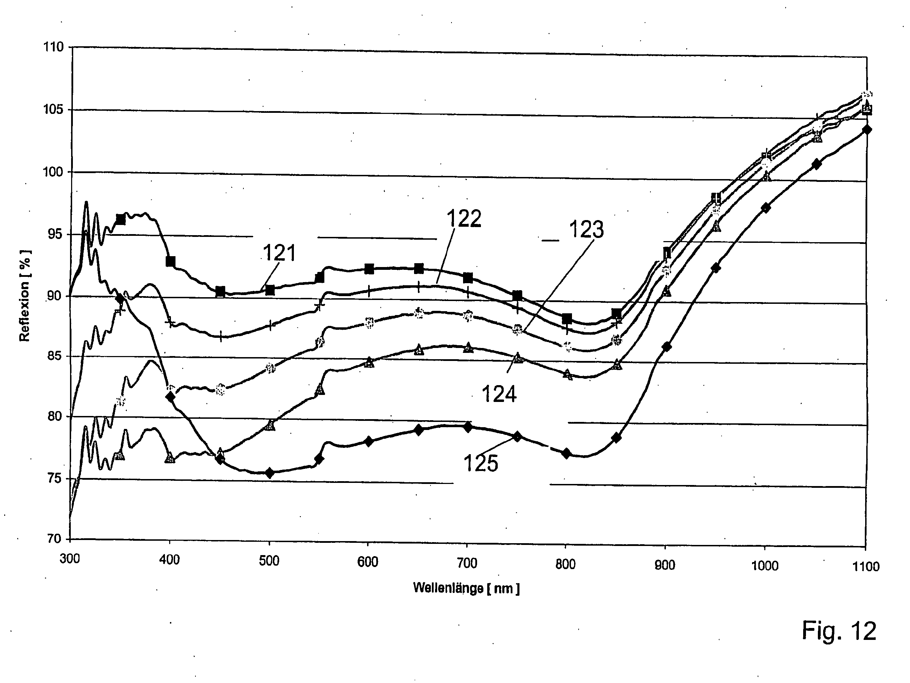

Mit Hilfe der automatischen Beschichtungsvorrichtung gemäß den Figuren 1 bis 3 wird ein 50.50 mm² großes Aluminiumblech von 0,5 mm Dicke auf seiner spiegelnden Seite wieder mit einer Si, O und H enthaltenden Schicht der allgemeinen Zusammensetzung SiOₓ(OH)(₄₋₂ₓ) (x = 0-2) beschichtet. Die Beflammung geschieht mit 2 bis 8 Durchläufen und mit einer Geschwindigkeit von 50 mm/s und einem Beflammungsabstand von 40 mm. Als oxidierendes Medium wird ein Luftstrom von 200 l/min benutzt. Die Luft wird mit einem Brenngas gemischt, das aus mit 0,3 Vol% Hexamethydisiloxan dotiertem Propan besteht und mit 81/min zugeführt wird. Das Substrat wird vor der Beflammung im Umluftofen auf 80 °C vorgewärmt. Während der Beschichtung wird eine Temperplatte als Gegenkühlung mit 80 °C verwendet. Nach dem Abkühlen wird das beschichtete Substrat spektroskopisch in Reflexion mit Hilfe einer Ulbrichtkugel bei 8° Neigung vermessen. Die Reflexionsminderung bis zu 15 % und ist aus Fig. 12 entnehmbar. Darin stellt die Kurve 121 die Reflexion des unbeschichteten Aluminiumsubstrates dar. Die Kurve 122 zeigt die Reflexion nach einem Beschichtungsdurchlauf. Die Kurve 123 zeigt die Reflexion nach zwei Beschichtungsdurchläufen. Die Kurve 124 ergibt sich bei vier Beschichtungsdurchläufen und die Kurve 125 bei acht Beschichtungsdurchläufen. Insgesamt lässt sich eine deutliche Reflexionsminderung in Abhängigkeit von der Beschichtung bzw. Beschichtungsdicke erkennen.

Alle in der Beschreibung, den nachfolgenden Ansprüchen und der Zeichnung dargestellten Merkmale können sowohl einzeln als auch in beliebiger Kombination miteinander erfindungswesentlich sein.

### Bezugszeichenliste

- 20: Brenner
- 21: Flamme (Flammen)
- 22: Substrat
- 23: Träger
- 24: Doppelpfeil
- 25: Beheizungseinrichtung
- 26: Precursor
- 27: Dosierungseinrichtung
- 28: Mischsystem
- 29: Brenngas-Oxydatorregelung
- 30: Brenngas
- 31: Oxydator
- 32: Sensorsystem mit Anzeige
- 33: Schicht
- 34: Partikel
- 35: Beschichtungsvorrichtung
- 41,42,43,44,51,52,53,:
- 54, 61, 62, 63, 71, 72, 73,:
- 81, 82, 83, 91, 92, 93, 101,:
- 102, 111, 112, 121,:
- 122, 123, 124, 125: Kurven

## Patentansprüche

1. Verwendung einer optischen Schicht als Entspiegelungsschicht zur Transmissinsverbesserung und/oder Reflexionsverminderung, hergestellt durch ein Verfahren der Flammenbeschichtung auf Substraten wobei von mindestens einer Kohlenwasserstoff und/oder Wasserstoffflamme ein siliziumhaltiger Precursor thermisch und/oder hydrolytisch mit Hilfe eines Oxydators zersetzt wird und sich direkt aus der Gasphase auf dem Substrat als SiOₓ(OH)₍₄₋₂ₓ₎-Schicht niederschlägt, worin 0 <x<= 2 ist, und die SiOₓ(OH)₍₄₋₂ₓ₎-Schicht einen Rest-Kohlenstoffgehalt von 0 bis 10% aufweist.

2. Verwendung gemäß Anspruch 1, **dadurch gekennzeichnet, dass** zur Schichtherstellung das Substrat in die Kohlenwasserstoff- und/oder Wasserstoffflamme eingeführt wird.

3. Verwendung gemäß Anspruch 1, **dadurch gekennzeichnet, dass** vor und/oder während der Schichtherstellung das Substrat auf 20 bis 300° C, vorzugsweise auf 60 bis 120° C erwärmt wird.

4. Verwendung gemäß Anspruch 1, **dadurch gekennzeichnet, dass** eine Schichtdicke von 5 bis 200 nm, vorzugsweise von 20 bis 100 nm erzeugt wird.

5. Verwendung gemäß Anspruch 1, **dadurch gekennzeichnet, dass** als Precursoren organische Siliziumverbindungen dienen.

6. Verwendung gemäß Anspruch 1, **dadurch gekennzeichnet, dass** als Precursor eine anorganische Siliziumverbindung, bevorzugt SiCl₄ dient.

7. Verwendung gemäß Anspruch 1 oder 4, **dadurch gekennzeichnet, dass** eine Precursorkonzentration von 0,05 bis 5 Vol%/Liter Brenngas, vorzugsweise von 0,1 bis 1,0 Vol%/Liter Brenngas, bezogen auf 1 Si-Atom pro Molekül Precursor, eingestellt wird.

8. Verwendung gemäß Anspruch 1, **dadurch gekennzeichnet, dass** als Brenngas Butan oder Propan oder deren Gemische verwendet werden.

9. Verwendung gemäß Anspruch 1, **dadurch gekennzeichnet, dass** als Brenngas Erdgas verwendet wird.

10. Verwendung gemäß Anspruch 1, **dadurch gekennzeichnet, dass** als Oxydator Luft, Sauerstoff oder ein Gemisch beider verwendet wird.

11. Verwendung gemäß Anspruch 1, **dadurch gekennzeichnet, dass** der Abstand des Brenners vom Substrat auf 3 bis 200 mm, vorzugsweise auf 10 bis 60 mm eingestellt wird.

12. Verwendung gemäß Anspruch 9, **dadurch gekennzeichnet, dass** zu einer Schichtherstellung Brenner und Substrat ein oder mehrfach relativ zueinander bewegt werden.

13. Verwendung gemäß Anspruch 1, **dadurch gekennzeichnet, dass** ein Brenner verwendet wird, der eine thermische Leistung bezogen auf die Flammenaustrittsfläche von 0,5 bis 10 kW/10 cm², vorzugsweise von 6 kW/10cm² hat.

14. Verwendung gemäß Anspruch 1, **dadurch gekennzeichnet, dass** mehrere Brenner verwendet werden.

15. Verwendung gemäß Anspruch 1, **dadurch gekennzeichnet, dass** die hergestellten Schichten eine Rauhigkeit nach RMS von 3 bis 50 nm, bevorzugt 10 bis 25 nm aufweisen.

16. Verwendung gemäß mindestens einem der vorstehenden Ansprüche, **dadurch gekennzeichnet, dass** das Substrat aus Glas, Keramik, Kunststoff oder Metall ist.

## Claims

1. Use of an optical layer as anti-reflection layer for the improvement of transmission and/or the reduction of reflections, manufactured by a method of flame coating on substrates, wherein from at least one carbon hydrogen and/or hydrogen flame a silicon comprising pre-cursor is broken-down thermally and/or hydrolytic with the aid of an oxidant and deposits directly from the gas phase onto the substrate as a layer of SiOₓ(OH)(₄₋₂ₓ) wherein 0 < x ≤ 2, and wherein the layer of SiOₓ(OH)₍₄₋₂ₓ₎ comprises a residual amount of carbon from 0 - 10 %.

2. Use according to claim 1, **characterized in that** the substrate is moved into the carbon hydrogen and/or hydrogen flame for the production of the layer.

3. Use according to claim 1, **characterized in that** the substrate is heated to 20 to 300° Celsius, preferably to 60 to 120° Celsius before and/or during the production of the layer.

4. Use according to claim 1, **characterized in that** a layer thickness of from 5 - 200 nm, preferably of from 20 -100 nm is produced.

5. Use according to claim 1, **characterized in that** organic silicon compounds are used as pre-cursors.

6. Use according to claim 1, **characterized in that** an un-organic silicon compound is used as pre-cursor, preferably SiCl₄.

7. Use according to claim 1 or 4, **characterized in that** a precursor concentration of from 0.05 to 5 Vol.%/liter of combustion gas is adjusted, preferably of from 0.1 to 1.0 Vol.%/liter combustion gas, relating to one Si-atom per molecule of precursor.

8. Use according to claim 1, **characterized in that** butane or propane or mixtures thereof are used as combustion gas.

9. Use according to claim 1, **characterized in that** natural gas is used as combustion gas.

10. Use according to claim 1, **characterized in that** air, oxygen or a mixture of both is used as oxidant.

11. Use according to claim 1, **characterized in that** the distance of the burner to the substrate is adjusted to 3 to 200 mm, preferably to 10 to 60 mm.

12. Use according to claim 9, **characterized in that** burner and substrate are moved relative to each other once or several times for the production of a layer.

13. Use according to claim 1, **characterized in that** a burner is used, which has a thermic output relative to the flame discharge area of from 0.5 to 10 kW/10 cm², preferably of 6 kW/10 cm².

14. Use according to claim 1, **characterized in that** several burners are used.

15. Use according to claim 1, **characterized in that** the produced layers have a roughness according to RMS of from 3 to 50 nm, preferably 10 to 25 nm.

16. Use according to any of the preceding claims, **characterized in that** the substrate is glass, ceramic, plastic or metal.

## Revendications

1. Utilisation d'une couche optique en tant que couche antiréfléchissante pour améliorer la transmission et/ou diminuer la réflexion, fabriquée par un procédé de dépôt à la flamme sur des substrats, un précurseur contenant du silicium étant, sous l'effet d'au moins une flamme de carbone et/ou d'hydrogène, soumis à une décomposition thermique et/ou hydrolytique à l'aide d'un oxydant, et se déposant directement à partir de la phase aqueuse sur le substrat sous forme d'une couche de SiOₓ(OH)₍₄₋₂ₓ₎, où 0<x<=2, la couche de SiOₓ(OH)₍₄₋₂ₓ₎ présentant une teneur résiduelle en carbone de 0 à 10 %.

2. Utilisation selon la revendication 1, **caractérisée en ce que**, pour fabriquer la couche, on introduit le substrat dans la flamme de carbone et/ou d'hydrogène.

3. Utilisation selon la revendication 1, **caractérisée en ce que** le substrat est, avant et/ou pendant la fabrication de la couche, chauffé à 20 à 300°C, de préférence à 60 à 120°C.

4. Utilisation selon la revendication 1, **caractérisée en ce qu'**on produit une épaisseur de couche de 5 à 200 nm, de préférence de 20 à 100 nm.

5. Utilisation selon la revendication 1, **caractérisée en ce que** ce sont des composés du silicium organique qui servent de précurseurs.

6. Utilisation selon la revendication 1, **caractérisée en ce que** c'est un composé du silicium inorganique, de préférence le SiCl₄, qui sert de précurseur.

7. Utilisation selon la revendication 1 ou 4, **caractérisée en ce qu'**on ajuste une concentration du précurseur de 0,05 à 5 % en volume/litre de gaz combustible, de préférence de 0,1 à 1,0 % en volume/litre de gaz combustible, rapportée à 1 atome de Si par molécule de précurseur.

8. Utilisation selon la revendication 1, **caractérisée en ce qu'**on utilise en tant que gaz combustible du butane ou du propane ou des mélanges de ceux-ci.

9. Utilisation selon la revendication 1, **caractérisée en ce qu'**on utilise en tant que gaz combustible du gaz naturel.

10. Utilisation selon la revendication 1, **caractérisée en ce qu'**on utilise en tant qu'oxydant l'air, l'oxygène ou un mélange des deux.

11. Utilisation selon la revendication 1, **caractérisée en ce que** la distance du brûleur au substrat est ajustée à une valeur de 3 à 200 mm et de préférence de 10 à 60 mm.

12. Utilisation selon la revendication 9, **caractérisée en ce que**, pour fabriquer une couche, on déplace une ou plusieurs fois, l'un par rapport à l'autre, le brûleur et le substrat.

13. Utilisation selon la revendication 1, **caractérisée en ce qu'**on utilise un brûleur qui a une puissance thermique, rapportée à l'aire de sortie de la flamme, de 0,5 à 10 kW/10 cm², de préférence de 6 kW/10 cm².

14. Utilisation selon la revendication 1, **caractérisée en ce qu'**on utilise plusieurs brûleurs.

15. Utilisation selon la revendication 1, **caractérisée en ce que** les couches fabriquées présentent une rugosité moyenne quadratique de 3 à 50 nm, de préférence de 10 à 25 nm.

16. Utilisation selon au moins l'une des revendications précédentes, **caractérisée en ce que** le substrat est constitué de verre, de céramique, de matière plastique ou d'un métal.
